# EUROPEAN PATENT APPLICATION

(11) **EP 4 712 303 A1**
(43) Date of publication of application: **18.03.2026**
(21) Application number: 25200050.0
(22) Date of filing: 03.09.2025
(51) Int. Cl.: H02J 7/40, B60L 58/16, G01R 31/371, H02J 7/84

(54) **SYSTEM AND METHOD FOR OPTIMIZING OPERATING STATE OF BATTERY USING A CLOUD**

(30) Priority: 11.09.2024 KR 20240124336
(71) Applicant: SAMSUNG SDI CO., LTD., Yongin-si, Gyeonggi-do 17084 (KR)
(72) Inventor: SIM, Sesup, 17084 Yongin-si (KR); CHO, Young Shin, 17084 Yongin-si (KR)
(74) Representative: Marks & Clerk LLP

(57) **Abstract**

A system for optimizing an operating state of a battery by using a cloud includes: a cloud unit configured to receive battery data; a first data collection unit configured to collect first data; a first data transmitter configured to transmit the first data to the cloud unit; a second data receiver configured to receive second data from the cloud unit; and a controller configured to control an operating state of a battery based on the second data and to perform any one of an update of first deterioration state information and an adjustment of a learning speed.

## Description

### BACKGROUND

### 1. Field

Aspects of embodiments of the present disclosure relate to a system and method for optimizing an operating state of a battery using a cloud.

### 2. Description of the Related Art

Different from primary batteries that are not designed to be (re)charged, secondary batteries are designed to be discharged and recharged. Low-capacity secondary batteries are used in small, portable electronic devices, such as smart phones, feature phones, notebook computers, digital cameras, and camcorders, while large-capacity secondary batteries are widely used as power sources for driving motors, such as of hybrid vehicles or electric vehicles, and for power storage. A secondary battery generally includes an electrode assembly including (or consisting of) a positive electrode and a negative electrode, a case that accommodates the electrode assembly, a terminal part connected to the electrode assembly, etc.

Generally, a battery management system (BMS) can accurately provide information, such as a deterioration state (State of Health (SoH)) (e.g., a capacity and internal resistance), when the BMS properly learns (or determines) the State of Charge (SOC), and accuracy of the deterioration state of a battery is important because battery reutilization and reuse are being required (e.g., by EU regulation). However, the accuracy of the deterioration state is also affected because a learning number is different for each BMS in various real-time conditions.

The above information disclosed in this Background section is for enhancement of understanding of the background of the present disclosure, and therefore, it may contain information that does not constitute related (or prior) art.

### SUMMARY

Embodiments of the present disclosure provide a system and method for optimizing an operating state of a battery by using a cloud, in which the statistical data of deterioration state values in similar use histories are provided to a battery management system (BMS) and the deterioration state of the BMS is updated or the learning speed of the BMS is controlled, by transmitting information, such as a battery use history and a deterioration state from the BMS, to a cloud and deriving, by the cloud, deterioration trend data of each BMS based on information collected by a plurality of BMSs and battery lifespan data obtained by a manufacturer and transmitting the deterioration trend data to each BMS.

However, aspects and feature of the present disclosure are not limited to those described above, and other aspects and features of the present disclosure will be understood by those skilled in the art from the description of the present disclosure below.

A system for optimizing an operating state of a battery by using a cloud, according to an embodiment of the present disclosure, includes a cloud unit configured to receive battery data, a first data collection unit configured to collect first data, a first data transmitter configured to transmit the first data to the cloud unit, a second data receiver configured to receive second data from the cloud unit, and a controller configured to control an operating state of a battery based on the second data and to perform any one of an update of first deterioration state information and an adjustment of a learning speed.

In embodiments, the first data collection unit may be configured to collect first use history information and the first deterioration state information.

In embodiments, the second data receiver may be configured to receive the second data having a value within an error range of the first data from the cloud unit.

In embodiments, the controller may be configured to update the first deterioration state information based on the received second data.

In embodiments, the cloud unit may be configured to compare the first data and the second data and, when a result of the comparison does not fall within a first error range, to transmit state learning instruction information for a battery management system (BMS) to the controller.

In embodiments, the cloud unit may be configured to compare the first data and the second data and, when a result of the comparison does not fall within a second error range, to transmit diagnosis request information for a battery management system (BMS) to a manager terminal.

In embodiments, the first error range may have a smaller value than the second error range.

A method of optimizing an operating state of a battery by using a cloud, according to an embodiment of the present disclosure, includes: receiving, by a cloud unit, battery data; collecting, by a first data collection unit, first data; transmitting, by a first data transmitter, the first data to the cloud unit; receiving, by a second data receiver, second data from the cloud unit; and controlling, by a controller, an operating state of a battery based on the second data and performing any one of updating first deterioration state information and adjusting a learning speed.

In embodiments, collecting of the first data may include collecting first use history information and the first deterioration state information.

In embodiments, the receiving of the second data may include receiving the second data having a value within a error range of the first data from the cloud unit.

In embodiments, the controlling of the operating state may include updating the first deterioration state information based on the received second data.

In embodiments, the receiving of the battery data may include comparing the first data and the second data and, when a result of the comparison does not fall within a first error range, transmitting state learning instruction information for a battery management system (BMS) to the controller.

In embodiments, the receiving of the battery data may include comparing the first data and the second data and, when a result of the comparison does not fall within a second error range, transmitting diagnosis request information for a battery management system (BMS) to a manager terminal.

An electric vehicle using the system for optimizing an operating state of a battery by using a cloud, according to an embodiment of the present disclosure, includes a cloud unit configured to store battery data, a first data collection unit configured to collect first data, a first data transmitter configured to transmit the first data to the cloud unit, a second data receiver configured to receive second data from the cloud unit, and a controller configured to control an operating state of a battery based on the second data and to perform any one of the update of first deterioration state information and the adjustment of a learning speed.

According to embodiments of the present disclosure, the BMS optimizes its deterioration state value while operating in conjunction with a cloud even if the BMS lacks state learning in a real use condition.

According to embodiments of the present disclosure, a cloud can properly determine the reuse and reutilization of products that are being used in the market by receiving deterioration state values into which battery use results have been incorporated from a BMS.

According to embodiments of the present disclosure, a cloud can determine whether or not it is necessary to diagnose a battery early.

However, aspects and features of the present disclosure are not limited to those described above, and other aspects and features not mentioned will be clearly understood by a person skilled in the art from the detailed description, described below.

At least some of the above and other features of the invention are set out in the claims.

### BRIEF DESCRIPTION OF THE DRAWINGS

The following drawings attached to this specification illustrate embodiments of the present disclosure and provide further understand the aspects, features, and technical scope of the present disclosure along with the aforementioned contents of the disclosure. Accordingly, the present disclosure should not be construed as being limited to only contents described in such drawings, in which:
FIG. 1 is a block diagram of a system for optimizing an operating state of a battery by using a cloud according to embodiments of the present disclosure.
FIG. 2 is a flowchart describing a method of optimizing an operating state of a battery by using a cloud according to embodiments of the present disclosure.
FIG. 3 is a block diagram describing a connection between a cloud and a BMS according to embodiments of the present disclosure.
FIG. 4 is a block diagram describing a cloud BMS.

### DETAILED DESCRIPTION

Embodiments of the present disclosure will be described below, in detail, with reference to the accompanying drawings. Prior to the description, it is noted that the terms or words used in this specification and claims should not be construed as being limited to their common or dictionary meanings but should be understood to have meanings and concepts in agreement with the scope of the present disclosure based on the principle that an inventor can define the concept of each term suitably in order to describe his/her own invention in the best way possible. Because the embodiments described in this specification and the configurations illustrated in the drawings are only examples of the present disclosure and do not cover all of the aspects, features, and the technical ideas of the present disclosure, it should be understood that various changes and modifications may be made at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art. The phrase "substantially the same" may include a deviation that is considered low in the art, for example, a deviation of about 5% or less. The uniformity of any parameter in a given region may mean that it is uniform from an average perspective.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein..

The terminology used herein is for the purpose of describing embodiments of the present disclosure and is not intended to limit the present disclosure.

The controller, cloud unit, terminal, and/or any other relevant devices or components (a "device") according to embodiments of the present disclosure described herein may be implemented utilizing any suitable hardware, firmware (e.g., an application-specific integrated circuit), software, and/or a suitable combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on a same substrate as the device. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device or the functionality of a particular computing device may be distributed across one or more other computing devices without departing from the scope of the example embodiments of the present disclosure.

The present disclosure will be described, in detail, with reference to the attached drawings.

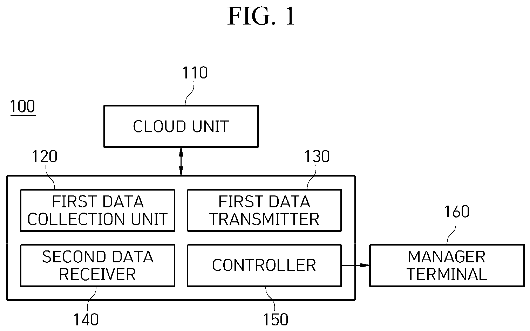

FIG. 1 is a block diagram of a system for optimizing an operating state of a battery by using a cloud according to embodiments of the present disclosure.

Referring to FIG. 1, a system 100 for optimizing an operating state of a battery by using a cloud may include a cloud unit 110, a first data collection unit 120, a first data transmitter 130, a second data receiver 140, and a controller 150. The system 100 may be located within an apparatus, such as a vehicle, alongside the battery for which the operation state is to be optimized.

The cloud unit 110 may receive a plurality of battery data. Furthermore, a battery management system (BMS) may include the first data collection unit 120, the first data transmitter 130, the second data receiver 140, and the controller 150. The cloud unit 110 may receive data from the cloud and may receive data from the BMS.

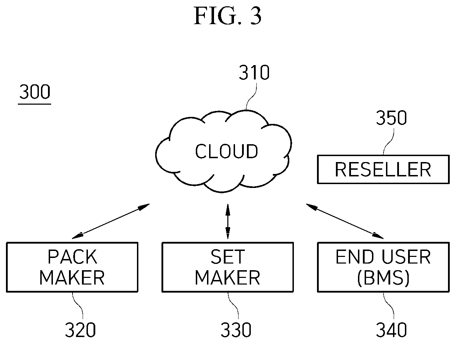

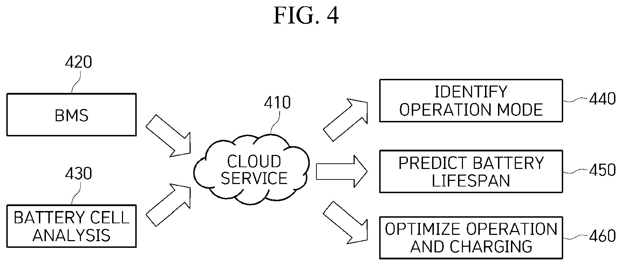

The cloud unit 110 and the BMS are described in more detail with reference to FIGS. 3 and 4. FIG. 3 is a schematic diagram describing a connection configuration of a cloud and a BMS according to embodiments of the present disclosure.

FIG. 4 is a schematic diagram describing a cloud BMS.

First, referring to FIG. 4, the cloud BMS is a cloud system-based BMS and may transmit battery information to a cloud and may process a large amount of data.

The cloud may refer to an IT (information technology) environment and/or platform, which includes a virtualized server that is accessible over a wide network and in which a server provides a program and a database. When the cloud is used, necessary computing resources can be easily used (e.g., can be remotely used) through the Internet. Cloud computing is a technical method using computing resources using a cloud and can provide a user with resources, such as a server, storage, and a network, by virtualizing the server, the storage, and the network and may expand or reduce the available resources. A cloud service refers to a service that is provided based on cloud computing and may be provided in various suitable forms. Representatively, the cloud service may refer to software as a service (SaaS), platform as a service (PasS), and infrastructure as a service (IaaS). The cloud refers to the provision of computing resources through the Internet in a conceptual sense. The cloud computing is a technique that implements the provision of computing resources in a technical aspect. Furthermore, the cloud service may refer to a service that is provided in various forms based on cloud computing. The cloud unit described herein may be configured to communicate with the cloud to utilize cloud computing resources to perform the processing tasks (e.g. comparison, analysis) described herein. In other embodiments, the cloud unit is configured to only retrieve data from the cloud and is itself configured to perform the processing tasks.

The BMS 420 may transmit BMS data to a cloud service 410 via the cloud unit. Aging model data may be transmitted to the cloud service through battery cell analysis 430 via the cloud unit. Data pre-processing, storage, and analysis platforms may be developed in a cloud. In the cloud BMS, operation environments are synchronized through the registration of a user profile (e.g. driver profile). Accordingly, a personal and optimized battery management service can be provided. Various types of data, may be collected in real time by operating a data center for the management of a full cycle history. For example, when the system is included in a vehicle, the collected data may include data such as a driver's habits, driving data, and data sensor information that is generated while driving. When the battery is deployed in alternative systems, other forms of data may also be collected including user data, data indicating operational use of the battery, and data sensor information that is generated while the battery is being used. When such data is stored in the cloud BMS, a battery can be managed for each person/vehicle.

If the current state of a battery reduces battery performance and lifespan, a manager may be informed of such a reduction. Accordingly, battery lifespan and performance can be maintained in an optimal state.

An operation mode having substantial damage may be identified (440) through the cloud BMS. A battery lifespan may be predicted (450). Battery stability may be managed through the optimization of an operation and charging (460).

Referring to FIG. 3, the cloud 310 may be mutually connected to a pack maker 320, a set maker 330, and an end user (BMS) 340 through communication. The end user (BMS) 340 is configured to communicate with the cloud 310 through the cloud unit 110.

The pack maker 320 may connect a cloud, a manufacturer, and a customer to facilitate maintenance and history management of a battery pack. The pack maker 320 may have (e.g., may store) cell information (e.g., a lot, a State of Health (SoH) according to a date, and full charge capacity (FCC) change information), that is, a major component or information of a battery, and may maintain a proper value by continuously learning the cell information for each use condition according to each product.

After the end user 340 is first registered for use, the BMS may transmit state information (e.g., SoH, FCC, a cycle, and use conditions (e.g., a temperature and a discharge C-rate) of a battery) to the cloud unit periodically or aperiodically.

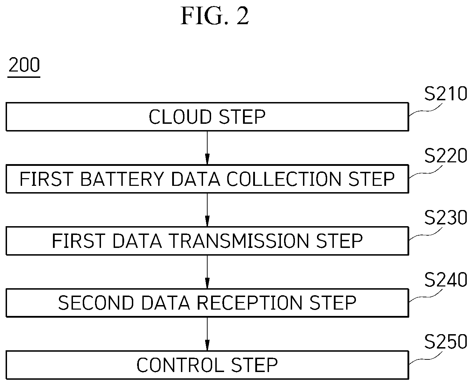

Furthermore, the BMS may be configured to update state information (e.g. SoH and FCC) in a learning process. The BMS may be updated with a value having high reliability only when learning conditions (e.g., a left time, a temperature, and a capacity change) are satisfied. The learning process may take place at a learning speed, which is a rate at which the BMS is configured to update the state information. A higher learning speed means that the BMS is configured to more regularly update the state information. The update of the state information of the learning process may be performed through the cloud unit as described herein. For example, at a higher learning speed, the method of Figure 2 may be performed more frequently.

When receiving information, such as the use conditions of the BMS, SoH, and FCC, the cloud unit 310 may compare the received information with the values of similar product groups/same cell lots or similar lots and may instruct the update of state information if a value has not been updated or a value falls outside an allowable (or reference) range for each cycle as a result of the comparison.

In embodiments of the present disclosure, when the update of the state information is instructed by the cloud unit 110, learning conditions may be changed based on a difference between current SoH and a target value and the number of operations. For example, a change may include a reduction or increase of a discharge capacity or an increase or reduction of a temperature region.

When a learning value (e.g. a value for state information to be changed) converges within a reference (or predetermined) range from a target value due to a changed condition, the learning value may be incorporated to update the corresponding value at the BMS. When the learning value falls outside the reference range, the learning conditions may be restored and an inability to process may be returned upon communication with the cloud unit 110.

When the holding of state information update is instructed by the cloud unit 110, the learning conditions may be reinforced. If the trend of a change, such as SoH, is the same even in the reinforced condition, the trend of the change may be notified upon communication with the cloud for use in diagnosis.

Furthermore, state information, such as FCC and SoH of the BMS, may be changed by the instruction of the cloud unit 110. In this case, an arbitrary value or a value having a valid learning function, which is calculated through the adjustment of an incorporation ratio of a learned value, may be incorporated into the state information.

The pack maker 320 may be connected to the cloud unit 310, a manufacturer, and the end user 340 to ensure easy maintenance and history management of a battery pack. The pack maker 320 may include SoH and FCC change information according to cell information (e.g., a lot, a date, a cycle, and use conditions (e.g., a discharge C-rate and a temperature)), that is, major components or information of a battery, and may maintain a proper value by continuously learning the SoH and FCC change information for each use condition according to each product.

When executing a reference (or predetermined) number of capacity learning in an adjusted condition, the BMS may operate by restoring to a design condition. When an error between a calculated value and a target value from the cloud is greater than a preset error value, the BMS may operate by restoring to the design condition without incorporating the error.

Referring back to FIG. 1, the first data collection unit 120 may collect first data. The first data may refer to first use history information and first deterioration state information. The first use history information may be first use history information of a first battery and the first deterioration state information may be first deterioration state information of the first battery. The first data may be received from the first battery or may be received from an additional processing element configured to determine the first data from collected battery data. For example, the processing element is configured to determine use history information and/or first deterioration state data from a sensor configured to measure properties of the first battery. The first battery may be the battery located in the apparatus alongside system 100.

The first data transmitter 130 may transmit the first data information collected by the first data collection unit 120 to the cloud unit 110. The second data receiver 140 may receive second data. The received second data may have a value within a reference (or preset) error range of the first data from the cloud. In such an embodiment, the value within the reference error range may mean that the value has use history information similar to that of a first battery. The second data may refer to second use history information and second deterioration state information of a second battery having use history information similar to those of the first battery. The second data may be received from the cloud unit 110.

The controller 140 may update the first deterioration state information of the first data based on the received second data. For example, the controller 140 may update the first deterioration state information based on an instruction received from the cloud unit 110, the instruction generated by the cloud unit 110 based on the received second data. Furthermore, the controller 150 may adjust the learning speed of the BMS of the first battery.

The cloud unit 110 may compare the first data and the second data. For example, the cloud unit 110 may utilize cloud computing resources to perform the comparison. When a result of the comparison does not fall within a first error range (e.g., a preset first error range), the cloud unit 110 may transmit, to the controller 140, learning instruction information to indicate BMS state learning.

Furthermore, the cloud unit 110 may compare the first data and the second data. When a result of the comparison does not fall within a second error range (e.g., a preset second error range), the cloud unit 110 may transmit, to a manager terminal 160, diagnosis request information to request the diagnosis of the BMS. In such an embodiment, the manager terminal may refer to all devices of a manager, which can receive the diagnosis request information and is not limited to a portable terminal.

Furthermore, the first error range may have a smaller value than the second error range. When it is determined that the result of the comparison is primarily greater than the first error range but falls outside of the second error range, the cloud unit 110 may transmit the diagnosis request information to the manager terminal.

In such an embodiment, the cloud unit 110 may receive use environments (e.g., a time for each use/left temperature, a use time for each discharge condition, and charging conditions (e.g., a temperature and a charging current)) from a plurality of BMSs, may record the use environments thereon, and may share information on the use environments of the plurality of BMSs through the cloud unit 110.

The BMS may have tracking information and may share the tracking information through the cloud unit 110.

After transmitting, to the cloud, a value that is newly learned by an instruction of the cloud unit 110, when receiving an instruction for an original condition, the BMS may restore to a value prior to the learning. After updating a state value by an instruction of the cloud unit 110, the BMS may write whether or not to execute an operation in an internal repository.

Furthermore, after updating the state value by (e.g., in response to) an instruction of the cloud unit 110, the operation of the BMS may be restored based on initial setting.

The cloud unit 110 may have cell characteristic information and pack configuration information and may operate an expected changed trend line for a state change, such as SoH and FCC, according to a calendar or a cycle, such as a product/use environment/cell lot, based on cell deterioration characteristic information.

Furthermore, when receiving the first data, the cloud unit 110 may compare and analyze the first data and the second data. In such an embodiment, the cloud unit 110 may compare and analyze the first data and the second data by using the expected changed trend line.

Furthermore, the cloud unit 110 may check (or may determine) whether or not to incorporate data upload. When a period in which the data upload onto the first battery has not been incorporated is out of a permissible period (e.g., a preset permissible per, the cloud unit 110 may transmit diagnosis instruction information to the manager terminal.

By implementing such embodiments of the present disclosure, the BMS can optimize a deterioration state value while operating in conjunction with the cloud although state learning is insufficient in real use conditions. By optimizing the deterioration state, the overall operating state of the battery can be optimized. For example, different operating processes may be adjusted according to the deterioration state, such as time taken to charge the battery, applied voltage in a charging operation, etc. The controller 150 of the BMS may be configured to control the operating state according to the deterioration state, which is updated based on the second data.

Furthermore, the cloud can determine the reuse and reutilization of products that are being used in the market by receiving the deterioration state value into which battery use results from the BMS has been incorporated.

Furthermore, the cloud may early determine whether or not to diagnose a battery.

FIG. 2 is a flowchart describing a method of optimizing an operating state of a battery by using a cloud according to embodiments of the present disclosure.

Referring to FIG. 2, in the method of optimizing an operating state of a battery by using a cloud, first, the cloud unit may receive a plurality of battery data. The plurality of battery data may include a use history and deterioration state information (S210).

Furthermore, the first data collection unit may collect first data information. The first data information may include first use history information and first deterioration state information of a first battery (S220).

The first data transmitter may transmit, to a cloud, the first data collected by the first data collection unit (S230).

The second data receiver may receive second data from the cloud. The second data may include second use history information and second deterioration state information of a second battery. The second battery may include a plurality of batteries except (e.g., other than) the first battery (S240).

The controller may control an operating state of the first battery based on the second data. The controller may update the first deterioration state information and may adjust the learning speed of the BMS of the first battery (S250).

Although the present disclosure has been described above in connection with example embodiments and drawings, the present disclosure is not limited to the embodiments described herein. A person having ordinary knowledge in the art to which the present disclosure pertains may modify and change the present disclosure within the technical scope of the present disclosure and the equivalent range of the following claims.

### DESCRIPTION OF SOME REFERENCE NUMERALS

| | | | |
|---|---|---|---|
| 110: | cloud unit | 120: | first data collection unit |
| 130: | first data transmitter | 140: | second data receiver |
| 150: | controller | 160: | manager terminal |

## Claims

1. A system for optimizing an operating state of a battery by using a cloud, the system comprising:
a cloud unit configured to receive battery data;
a first data collection unit configured to collect first data;
a first data transmitter configured to transmit the first data to the cloud unit;
a second data receiver configured to receive second data from the cloud unit;
and
a controller configured to control an operating state of a battery based on the second data and to perform any one of an update of first deterioration state information and an adjustment of a learning speed.

2. The system as claimed in claim 1, wherein the first data collection unit is configured to collect first use history information and the first deterioration state information.

3. The system as claimed in claim 1 or claim 2, wherein the second data receiver is configured to receive the second data having a value within an error range of the first data from the cloud unit.

4. The system as claimed in any preceding claim, wherein the controller is configured to update the first deterioration state information based on the received second data.

5. The system as claimed in claim 4, wherein the cloud unit is configured to compare the first data and the second data and, when a result of the comparison does not fall within a first error range, to transmit state learning instruction information for a battery management system (BMS) to the controller.

6. The system as claimed in claim 5, wherein the cloud unit is configured to compare the first data and the second data and, when a result of the comparison does not fall within a second error range, to transmit diagnosis request information for a battery management system (BMS) to a manager terminal.

7. The system as claimed in claim 6, wherein the first error range has a smaller value than the second error range.

8. A method of optimizing an operating state of a battery by using a cloud, the method comprising:
receiving, by a cloud unit, battery data;
collecting, by a first data collection unit, first data;
transmitting, by a first data transmitter, the first data to the cloud unit;
receiving, by a second data receiver, second data from the cloud unit; and
controlling, by a controller, an operating state of a battery based on the second data and performing any one of updating first deterioration state information and adjusting a learning speed.

9. The method as claimed in claim 8, wherein the collecting of the first data comprises collecting first use history information and the first deterioration state information.

10. The method as claimed in claim 8 or claim 9, wherein the receiving of the second data comprises receiving the second data having a value within a error range of the first data from the cloud unit.

11. The method as claimed in any one of claims 8 - 10, wherein the controlling of the operating state comprises updating the first deterioration state information based on the received second data.

12. The method as claimed in any one of claims 8 - 10, wherein the receiving of the battery data comprises comparing the first data and the second data and, when a result of the comparison does not fall within a first error range, transmitting state learning instruction information for a battery management system (BMS) to the controller.

13. The method as claimed in claim 11, wherein the receiving of the battery data comprises comparing the first data and the second data and, when a result of the comparison does not fall within a second error range, transmitting diagnosis request information for a battery management system (BMS) to a manager terminal.

14. An electric vehicle comprising a system according to any one of claims 1 - 7, wherein the cloud unit is further configured to store the battery data.
